# EUROPEAN PATENT APPLICATION

(11) **EP 2 398 114 A1**
(43) Date of publication of application: **21.12.2011**
(21) Application number: 10165932.4
(22) Date of filing: 15.06.2010
(51) Int. Cl.: H01R 13/24, H05K 9/00

(54) **Spring finger grounding component and method of manufacture**

(71) Applicant: Research in Motion Limited, Waterloo, Ontario N2L 3W8 (CA)
(72) Inventor: Chen, Chao, Waterloo Ontario N2L 3W8 (CA); Zhang, Richard Changchun, Waterloo Ontario N2L 3X2 (CA)
(74) Representative: Moore, Barry

(57) **Abstract**

A grounding component (400, 400', 400") is provided for grounding electronic components (550). The grounding component (400, 400', 400") includes: a base (410); a channel (430) formed within the base (410); and a spring finger (420) extending from the base (410), the spring finger (420) having a fixed end (422) and a free end (424). When the spring finger (420) is in a first undepressed position, a knuckled portion 426 of the spring finger (420) lies proud of the base (410), and the free end (424) of the spring finger (420) lies substantially within the channel (430). A method for manufacturing the grounding component is also provided.

## Description

The field of the invention relates generally to components used to provide a reference ground to electronic components.

Electronic components must typically be grounded. Grounding components may be utilized to accomplish this. Continuous electrical engagement between the electronic component and the grounding component is required for the grounding component to be effective.

### General

In one broad aspect, there may be provided a grounding component. The grounding component may comprise: a grounded base; a channel formed within the base; and a spring finger extending from the base, the spring finger having a fixed end and a free end. When the spring finger is in a first undepressed position, a knuckled portion of the spring finger lies proud of the base, and the free end of the spring finger lies substantially within the channel.

In some instances, the base of the grounding component may comprise a top plate secured to a bottom plate. In such instances, the channel formed in the base may extend through the entire thickness of the top plate. Furthermore, the spring finger may be stamped from the top plate and displaced to form the channel within the top plate.

In other instances, when the spring finger may be in a second depressed position, an electrical connection may be established between the bottom plate and the free end of the spring finger.

The fixed end of the spring finger may be welded to the base and may comprise a conductive material. The top plate and bottom plate may be secured together using an adhesive, or may be welded together to form a weldment. Where an adhesive is used, the adhesive may be conductive or non-conductive. Where a non-conductive adhesive is used, an electrical connection may be established between the top plate and the bottom plate through the spring finger, when the spring finger is in the second depressed position.

In some instances, the grounding component may have a plurality of spring fingers and channels, comprising at least one second channel and at least one second spring finger.

In another broad aspect, there may be provided a grounding system comprising: a grounded base having a top plate secured to a bottom plate; a channel formed within the top plate; and a cantilevered member extending from the base, the cantilevered member being flexibly biased towards a first undepressed position. When the cantilevered member is in a second depressed position, an electrical connection may be established between the cantilevered member and the bottom plate.

In some instances, the cantilevered member may have a free end and a fixed end, and when the cantilevered member is in the first undepressed position, a knuckled portion of the cantilevered member may lie proud of the base, and the free end of the cantilevered member may lie within the channel. When the cantilevered member is in the first undepressed position, in some embodiments the top plate and the bottom plate may not be in electrical communication with one another.

In other instances, the grounding system may be further configured for receivably mounting an electronic component to the base such that when the electronic component is mounted to the base, an electrical connection may be established between an electrical contact point of the electronic component and the base through the cantilevered member. The electronic component may comprise a printed circuit board assembly. Further, a keypad assembly may be coupled to the printed circuit board assembly.

In another broad aspect, there may be provided an assembly for grounding an electronic component comprising: a grounded base; a channel formed in the base; a cantilevered member extending from the base, the cantilevered member being flexibly biased towards a first position, and having a fixed end and a free end. When the cantilevered member is in an undepressed position, a knuckled portion of the cantilevered member may lie proud of the base and the free end of the cantilevered member may lie substantially within the channel. When an electronic component is mounted to the base, an electrical connection may be established between the base and the electronic component through the cantilevered member.

In some instances, the cantilevered member may comprise a conductive material. In other instances, at least a portion of the base comprises a conductive material for reducing electro-magnetic interference emissions generated from the electronic component. The electronic component may be a printed circuit board assembly, and the printed circuit board assembly may be mounted within a mobile device. Further, a keypad assembly may be coupled to the printed circuit board assembly.

According to another broad aspect, there may be provided a method of manufacture for a grounding component. The method may comprise the steps of: providing a grounded base having a top plate and a bottom plate; stamping a spring finger from a portion of the top plate, the spring finger having a fixed end and a free end; displacing the spring finger to form a channel within the top plate; forming a knuckled portion in the spring finger; and configuring the spring finger such that the knuckled portion lies proud of the base and the free end lies substantially within the channel.

According to another broad aspect, there may be provided another method of manufacturing a grounding component. The method may comprise the steps of: providing a base having a channel; providing a spring finger having a first end and a second end; coupling the first end of the spring finger to the base; positioning the second end of the spring finger substantially within the channel; positioning a knuckled portion of the spring finger proud of the base. In some instances the first end of the spring finger may be welded to the base. In other instances, an adhesive may be used to couple the first end of the spring finger to the base.

In another broad aspect, there may be provided a method for grounding an electronic component. The method may comprise the steps of: providing a grounded base having a channel; configuring a spring finger to extend from a portion of the base, wherein when in an undepressed position, a free end of the spring finger lies substantially within the channel and a knuckled portion of the spring finger lies proud of the base; and operatively coupling an electrical contact point of the electronic component to the knuckled portion of the spring finger to establish an electrical connection between the electronic component and the base through the spring finger.

Some embodiments of the systems and methods described herein make reference to a mobile device. A mobile device may be a two-way communication device with advanced data communication capabilities having the capability to communicate with other computer systems. A mobile device may also include the capability for voice communications. Depending on the functionality provided by a mobile device, it may be referred to as a data messaging device, a two-way pager, a cellular telephone with data messaging capabilities, a wireless Internet appliance, or a data communication device (with or without telephony capabilities), for example. A mobile device may communicate with other devices through a network of transceiver stations.

### Brief Description of the Drawings

Embodiments are described in further detail below, by way of example only, with reference to the accompanying drawings, in which:
**FIG. 1** is a block diagram of a mobile device in one example implementation;
**FIG. 2** is a block diagram of a communication subsystem component of the mobile device of **FIG. 1****;**
**FIG. 3** is a block diagram of a node of a wireless network;
**FIG. 4A** is a perspective view of a grounding component according to an embodiment of the present invention;
**FIG. 4B** is a side section view of the grounding component of **FIG. 4A** taken along section line A4―A4 and in the direction indicated, and illustrates the grounding component in a first undepressed position;
**FIG. 4C** is a side section view of the grounding component of **FIG. 4A** taken along section line A4―A4 and in the direction indicated, and illustrates the grounding component in a second depressed position;
**FIG. 5A** is a perspective view of a grounding component according to another embodiment of the present invention;
**FIG. 5B** is a side section view of the grounding component of **FIG. 5A** taken along section line A5―A5 and in the direction indicated, and illustrates the grounding component in a first undepressed position;
**FIG. 5C** is a side section view of the grounding component of **FIG. 5A** taken along section line A5―A5 and in the direction indicated, and illustrates the grounding component in a second depressed position;
**FIG. 5D** is a side section view of the grounding component of **FIG. 5A** taken along section line A5―A5 and in the direction indicated, and depicts an electronic component causing the grounding component to assume the second depressed position;
**FIG. 6A** is a perspective view of a grounding component according to another embodiment of the present invention;
**FIG. 6B** is a side section view of the grounding component of **FIG. 6A** taken along section line A6―A6 and in the direction indicated, and illustrates the grounding component in a first undepressed position;
**FIG. 6C** is a side section view of the grounding component of **FIG. 6A** taken along section line A6―A6 and in the direction indicated, and illustrates the grounding component in a second depressed position;
**FIG. 7** is a logical flow diagram of a method for manufacturing a grounding component according to an embodiment of the present invention; and
**FIG. 8** is a logical flow diagram of a method of grounding an electronic component according to an embodiment of the present invention.

### Description of Preferred Embodiments

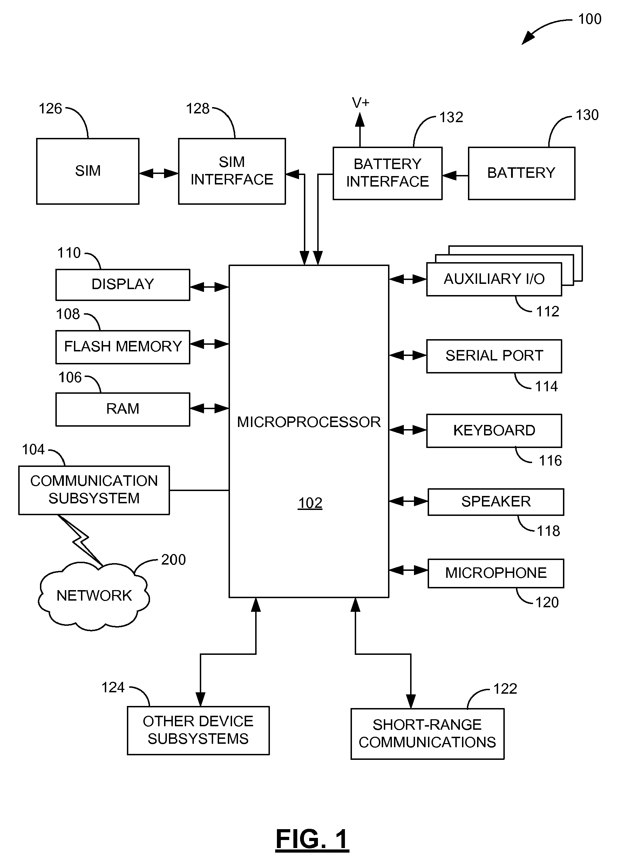

To aid the reader in understanding the structure of a mobile device and how it communicates with other devices, reference is made to **FIGS. 1** through **3****.**

Referring first to **FIG. 1****,** a block diagram of a mobile device in one example implementation is shown generally as **100.** Mobile device **100** comprises a number of components, the controlling component being microprocessor **102.** Microprocessor **102** controls the overall operation of mobile device **100.** Communication functions, including data and voice communications, may be performed through communication subsystem **104.** Communication subsystem **104** may be configured to receive messages from and send messages to a wireless network **200.** In one example implementation of mobile device **100,** communication subsystem **104** may be configured in accordance with the Global System for Mobile Communication (GSM) and General Packet Radio Services (GPRS) standards. The GSM/GPRS wireless network is used worldwide and it is expected that these standards may be supplemented or superseded eventually by Enhanced Data GSM Environment (EDGE) and Universal Mobile Telecommunications Service (UMTS), and Ultra Mobile Broadband (UMB), etc. New standards are still being defined, but it is believed that they will have similarities to the network behaviour described herein, and it will also be understood by persons skilled in the art that the embodiments of the present disclosure are intended to use any other suitable standards that are developed in the future. The wireless link connecting communication subsystem **104** with network **200** represents one or more different Radio Frequency (RF) channels, operating according to defined protocols specified for GSM/GPRS communications. With newer network protocols, these channels are capable of supporting both circuit switched voice communications and packet switched data communications.

Although the wireless network associated with mobile device **100** is a GSM/GPRS wireless network in one example implementation of mobile device **100,** other wireless networks may also be associated with mobile device **100** in variant implementations. Different types of wireless networks that may be employed include, for example, data-centric wireless networks, voice-centric wireless networks, and dual-mode networks that can support both voice and data communications over the same physical base stations. Combined dual-mode networks include, but are not limited to, Code Division Multiple Access (CDMA) or CDMA2000 networks, GSM/GPRS networks (as mentioned above), and future third-generation (3G) networks like EDGE and UMTS. Some older examples of data-centric networks include the Mobitex™ Radio Network and the DataTAC™ Radio Network. Examples of older voice-centric data networks include Personal Communication Systems (PCS) networks like GSM and Time Division Multiple Access (TDMA) systems. Other network communication technologies that may be employed include, for example, Integrated Digital Enhanced Network (iDEN™**)**, Evolution-Data Optimized (EV-DO), and High Speed Packet Access (HSPA), etc.

Microprocessor **102** may also interact with additional subsystems such as a Random Access Memory (RAM) **106,** flash memory **108,** display **110,** auxiliary input/output (I/O) subsystem **112,** serial port **114,** keyboard **116,** speaker **118,** microphone **120,** short-range communications subsystem **122** and other device subsystems **124.**

Some of the subsystems of mobile device **100** perform communication-related functions, whereas other subsystems may provide "resident" or on-device functions. By way of example, display **110** and keyboard **116** may be used for both communication-related functions, such as entering a text message for transmission over network **200,** as well as device-resident functions such as a calculator or task list. Operating system software used by microprocessor **102** is typically stored in a persistent store such as flash memory 108, which may alternatively be a read-only memory (ROM) or similar storage element (not shown). Those skilled in the art will appreciate that the operating system, specific device applications, or parts thereof, may be temporarily loaded into a volatile store such as RAM **106.**

Mobile device **100** may send and receive communication signals over network **200** after network registration or activation procedures have been completed. Network access may be associated with a subscriber or user of a mobile device **100.** To identify a subscriber, mobile device **100** may provide for a Subscriber Identity Module ("SIM") card **126** to be inserted in a SIM interface **128** in order to communicate with a network. SIM **126** may be one example type of a conventional "smart card" used to identify a subscriber of mobile device **100** and to personalize the mobile device **100,** among other things. Without SIM **126,** mobile device **100** may not be fully operational for communication with network **200.** By inserting SIM **126** into SIM interface **128,** a subscriber may access all subscribed services. Services may include, without limitation: web browsing and messaging such as e-mail, voice mail, Short Message Service (SMS), and Multimedia Messaging Services (MMS). More advanced services may include, without limitation: point of sale, field service and sales force automation. SIM **126** may include a processor and memory for storing information. Once SIM **126** is inserted in SIM interface **128,** it may be coupled to microprocessor **102.** In order to identify the subscriber, SIM **126** may contain some user parameters such as an International Mobile Subscriber Identity (IMSI). By using SIM **126,** a subscriber may not necessarily be bound by any single physical mobile device. SIM **126** may store additional subscriber information for a mobile device as well, including datebook (or calendar) information and recent call information.

Mobile device **100** may be a battery-powered device and may comprise a battery interface **132** for receiving one or more rechargeable batteries **130.** Battery interface **132** may be coupled to a regulator (not shown), which assists battery **130** in providing power V+ to mobile device **100.** Although current technology makes use of a battery, future technologies such as micro fuel cells may provide power to mobile device **100.** In some embodiments, mobile device **100** may be solar-powered.

Microprocessor **102,** in addition to its operating system functions, enables execution of software applications on mobile device **100.** A set of applications that control basic device operations, including data and voice communication applications, may be installed on mobile device **100** during its manufacture. Another application that may be loaded onto mobile device **100** is a personal information manager (PIM). A PIM has functionality to organize and manage data items of interest to a subscriber, such as, but not limited to, e-mail, calendar events, voice mails, appointments, and task items. A PIM application has the ability to send and receive data items via wireless network **200.** PIM data items may be seamlessly integrated, synchronized, and updated via wireless network **200** with the mobile device subscriber's corresponding data items stored and/or associated with a host computer system. This functionality may create a mirrored host computer on mobile device **100** with respect to such items. This can be particularly advantageous where the host computer system is the mobile device subscriber's office computer system.

Additional applications may also be loaded onto mobile device **100** through network **200,** auxiliary I/O subsystem **112,** serial port **114,** short-range communications subsystem **122,** or any other suitable subsystem **124.** This flexibility in application installation increases the functionality of mobile device **100** and may provide enhanced on-device functions, communication-related functions, or both. For example, secure communication applications may enable electronic commerce functions and other such financial transactions to be performed using mobile device **100.**

Serial port **114** enables a subscriber to set preferences through an external device or software application and extends the capabilities of mobile device **100** by providing for information or software downloads to mobile device **100** other than through a wireless communication network. The alternate download path may, for example, be used to load an encryption key onto mobile device 100 through a direct and thus reliable and trusted connection to provide secure device communication.

Short-range communications subsystem **122** provides for communication between mobile device **100** and different systems or devices, without the use of network **200.** For example, subsystem **122** may include an infrared device and associated circuits and components for short-range communication. Examples of short range communication include standards developed by the Infrared Data Association (IrDA), Bluetooth^{®}, and the 802.11 family of standards (Wi-Fi^{®}) developed by IEEE.

In use, a received signal such as a text message, an e-mail message, or web page download is processed by communication subsystem **104** and input to microprocessor **102.** Microprocessor **102** then processes the received signal for output to display **110** or alternatively to auxiliary I/O subsystem **112.** A subscriber may also compose data items, such as e-mail messages, for example, using keyboard 116 in conjunction with display **110** and possibly auxiliary I/O subsystem **112.** Auxiliary subsystem **112** may include devices such as: a touch screen, mouse, track ball, infrared fingerprint detector, or a roller wheel with dynamic button pressing capability. Keyboard 116 may comprise an alphanumeric keyboard and/or telephone-type keypad, for example. A composed item may be transmitted over network **200** through communication subsystem **104.**

For voice communications, the overall operation of mobile device **100** may be substantially similar, except that the received signals may be processed and output to speaker **118,** and signals for transmission may be generated by microphone **120.** Alternative voice or audio I/O subsystems, such as a voice message recording subsystem, may also be implemented on mobile device **100.** Although voice or audio signal output is accomplished primarily through speaker **118,** display **110** may also be used to provide additional information such as the identity of a calling party, duration of a voice call, or other voice call related information.

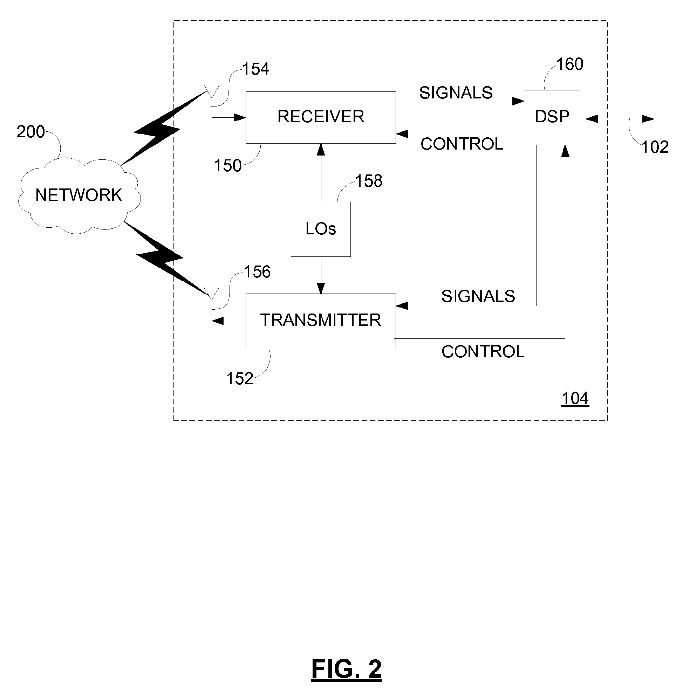

Referring now to **FIG. 2****,** a block diagram of the communication subsystem component **104** of **FIG. 1** is shown. Communication subsystem **104** may comprise a receiver **150,** a transmitter **152,** one or more embedded or internal antenna elements **154, 156,** Local Oscillators (LOs) **158,** and a processing module such as a Digital Signal Processor (DSP) 160.

The particular design of communication subsystem **104** is dependent upon the network **200** in which mobile device **100** is intended to operate; thus, it should be understood that the design illustrated in **FIG. 2** serves only as one example. Signals received by antenna **154** through network **200** are input to receiver **150,** which may perform such common receiver functions as signal amplification, frequency down conversion, filtering, channel selection, and analog-to-digital (A/D) conversion. A/D conversion of a received signal allows more complex communication functions such as demodulation and decoding to be performed in DSP **160.** In a similar manner, signals to be transmitted are processed, including modulation and encoding, by DSP **160.** These DSP-processed signals are input to transmitter **152** for digital-to-analog (D/A) conversion, frequency up conversion, filtering, amplification and transmission over network **200** via antenna **156.** DSP **160** not only processes communication signals, but also provides for receiver and transmitter control. For example, the gains applied to communication signals in receiver **150** and transmitter **152** may be adaptively controlled through automatic gain control algorithms implemented in DSP **160.**

The wireless link between mobile device **100** and a network **200** may contain one or more different channels, typically different RF channels, and associated protocols used between mobile device **100** and network **200.** A RF channel is generally a limited resource, typically due to limits in overall bandwidth and limited battery power of mobile device **100.**

When mobile device **100** is fully operational, transmitter **152** may be typically keyed or turned on only when it is sending to network **200** and may otherwise be turned off to conserve resources. Similarly, receiver **150** may be periodically turned off to conserve power until it is needed to receive signals or information (if at all) during designated time periods.

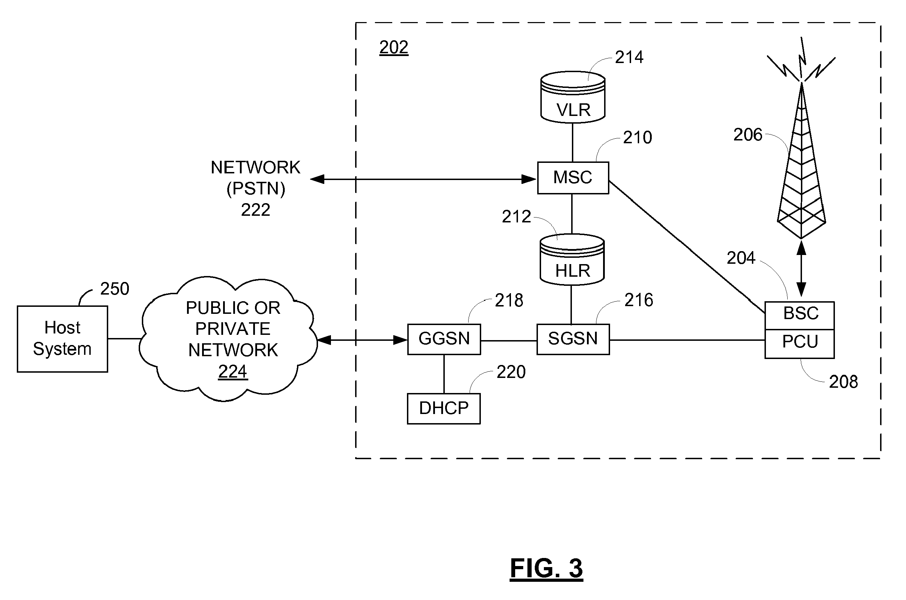

Referring now to **FIG. 3****,** a block diagram of a node of a wireless network is shown as **202.** In practice, network **200** comprises one or more nodes **202.** Mobile device **100** communicates with a node **202** within wireless network **200.** In the example implementation of **FIG. 3****,** node **202** is configured in accordance with GPRS and GSM technologies; however, in other embodiments, different standards may be implemented as discussed in more detail above. Node **202** includes a base station controller (BSC) **204** with an associated tower station **206,** a Packet Control Unit (PCU) **208** added for GPRS support in GSM, a Mobile Switching Center (MSC) **210,** a Home Location Register (HLR) **212,** a Visitor Location Registry (VLR) **214,** a Serving GPRS Support Node (SGSN) **216,** a Gateway GPRS Support Node (GGSN) **218,** and a Dynamic Host Configuration Protocol (DHCP) server **220.** This list of components is not meant to be an exhaustive list of the components of every node **202** within a GSM/GPRS network, but rather a list of components that are commonly used in communications through network **200.**

In a GSM network, MSC **210** is coupled to BSC **204** and to a landline network, such as a Public Switched Telephone Network (PSTN) **222** to satisfy circuit switched requirements. The connection through PCU **208,** SGSN **216** and GGSN **218** to the public or private network (Internet) **224** (also referred to herein generally as a shared network infrastructure) represents the data path for GPRS capable mobile devices. In a GSM network extended with GPRS capabilities, BSC **204** also contains a Packet Control Unit (PCU) **208** that connects to SGSN **216** to control segmentation, radio channel allocation and to satisfy packet switched requirements. To track mobile device location and availability for both circuit switched and packet switched management, HLR **212** is shared between MSC **210** and SGSN **216.** Access to VLR **214** is controlled by MSC **210.**

Station **206** may be a fixed transceiver station. Station **206** and BSC 204 together may form the fixed transceiver equipment. The fixed transceiver equipment provides wireless network coverage for a particular coverage area commonly referred to as a "cell". The fixed transceiver equipment transmits communication signals to and receives communication signals from mobile devices within its cell via station **206.** The fixed transceiver equipment normally performs such functions as modulation and possibly encoding and/or encryption of signals to be transmitted to the mobile device in accordance with particular, usually predetermined, communication protocols and parameters, under control of its controller. The fixed transceiver equipment similarly demodulates and possibly decodes and decrypts, if necessary, any communication signals received from mobile device **100** within its cell. Communication protocols and parameters may vary between different nodes. For example, one node may employ a different modulation scheme and operate at different frequencies than other nodes.

For all mobile devices **100** registered with a specific network, permanent configuration data such as a user profile may be stored in HLR **212.** HLR **212** may also contain location information for each registered mobile device and can be queried to determine the current location of a mobile device. MSC **210** is responsible for a group of location areas and stores the data of the mobile devices currently in its area of responsibility in VLR **214.** Further VLR **214** also contains information on mobile devices that are visiting other networks. The information in VLR **214** includes part of the permanent mobile device data transmitted from HLR **212** to VLR **214** for faster access. By moving additional information from a remote HLR **212** node to VLR **214,** the amount of traffic between these nodes can be reduced so that voice and data services can be provided with faster response times while requiring less use of computing resources.

SGSN **216** and GGSN **218** are elements that may be added for GPRS support; namely packet switched data support, within GSM. SGSN **216** and MSC **210** have similar responsibilities within wireless network **200** by keeping track of the location of each mobile device **100.** SGSN **216** also performs security functions and access control for data traffic on network **200.** GGSN **218** provides internetworking connections with external packet switched networks and connects to one or more SGSNs **216** via an Internet Protocol (IP) backbone network operated within the network **200.** During normal operations, a given mobile device **100** performs a "GPRS Attach" to acquire an IP address and to access data services. This normally is not present in circuit switched voice channels as Integrated Services Digital Network (ISDN) addresses may be generally used for routing incoming and outgoing calls. Currently, GPRS capable networks may use private, dynamically assigned IP addresses, thus requiring a DHCP server **220** connected to the GGSN **218.** There are many mechanisms for dynamic IP assignment, including using a combination of a Remote Authentication Dial-In User Service (RADIUS) server and DHCP server, for example. Once the GPRS Attach is complete, a logical connection is established from a mobile device **100,** through PCU **208,** and SGSN **216** to an Access Point Node (APN) within GGSN **218,** for example. The APN represents a logical end of an IP tunnel that can either access direct Internet compatible services or private network connections. The APN also represents a security mechanism for network **200,** insofar as each mobile device **100** must be assigned to one or more APNs and mobile devices **100** cannot generally exchange data without first performing a GPRS Attach to an APN that it has been authorized to use. The APN may be considered to be similar to an Internet domain name such as
"myconnection.wireless.com".

Once the GPRS Attach is complete, a tunnel is created and all traffic is exchanged within standard IP packets using any protocol that can be supported in IP packets. This includes tunneling methods such as IP over IP as in the case with some IPSecurity (IPsec) connections used with Virtual Private Networks (VPN). These tunnels are also referred to as Packet Data Protocol (PDP) Contexts and there are a limited number of these available in the network **200.** To maximize use of the PDP Contexts, network **200** will run an idle timer for each PDP Context to determine if there is a lack of activity. When a mobile device **100** is not using its PDP Context, the PDP Context can be deallocated and the IP address returned to the IP address pool managed by DHCP server **220.**

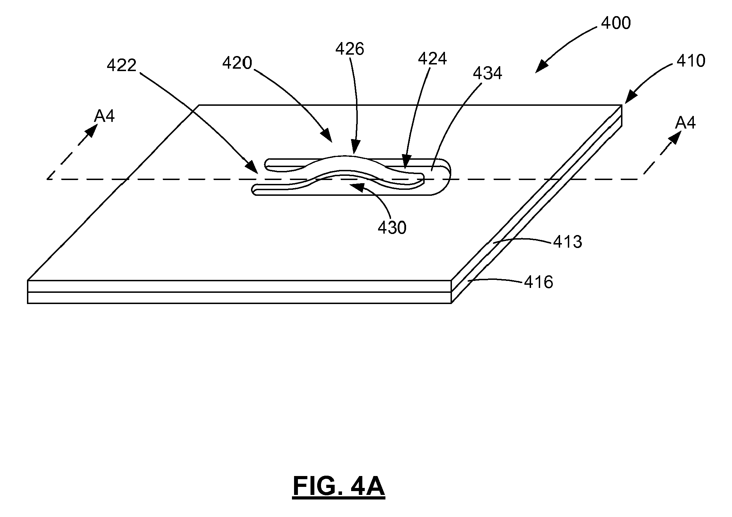

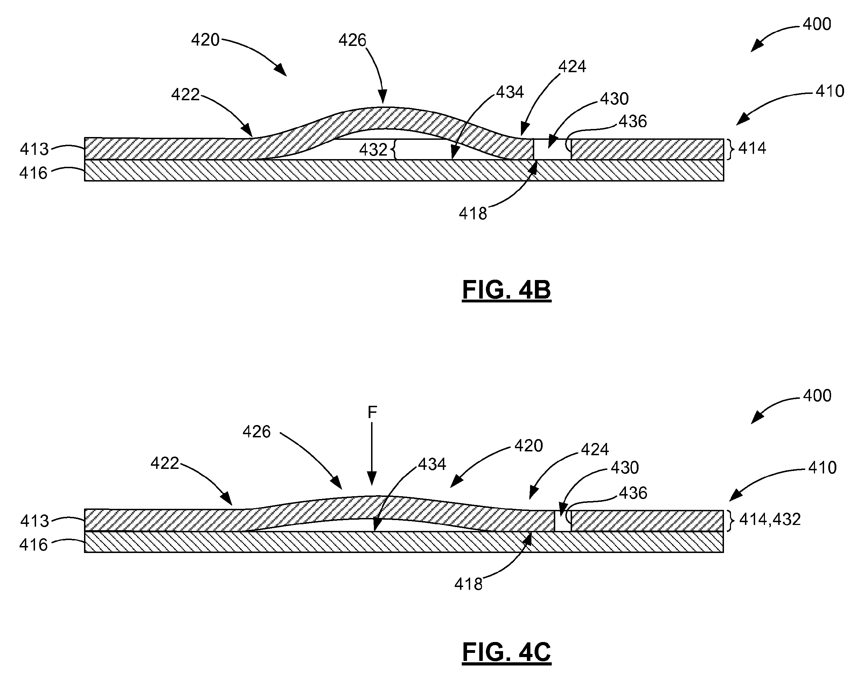

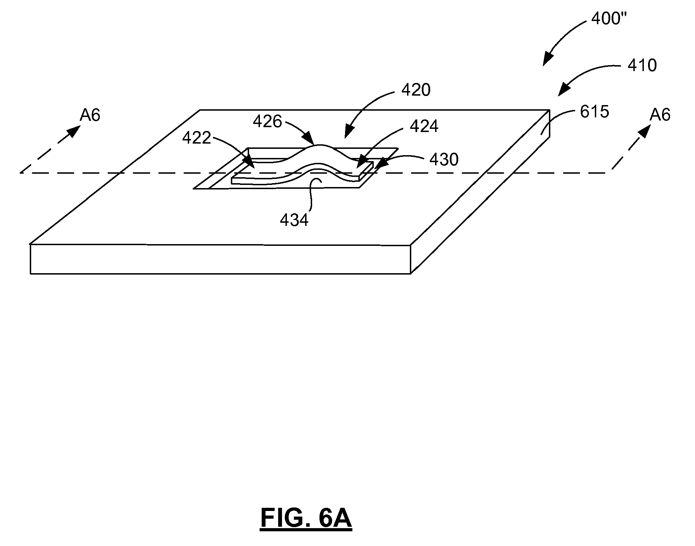

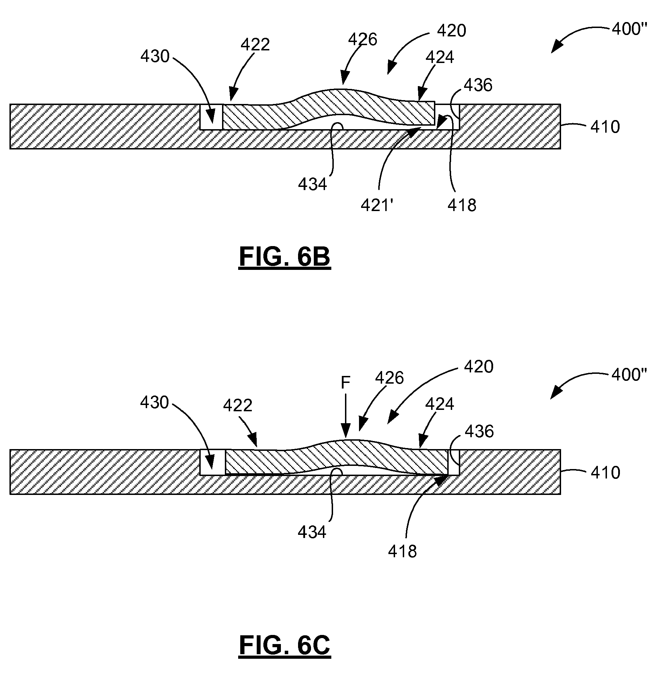

Referring now to **FIGS. 4A****,** **4B,** and **4C****,** a grounding component according to an embodiment of the present invention is shown generally as **400.** With specific reference to **FIG 4A****,** which shows a perspective view of the grounding component **400,** the grounding component **400** may have a grounded base **410.** The grounded base **410** is configured to act as a floating ground for an electronic component by providing a reference potential for the electronic component when an electrical connection is established between the base **410** and the electronic component. The base 410 may consist of a top plate **413** secured to a bottom plate **416.** Those of ordinary skill in the art will appreciate that the base **410** need not be made up of two plates. It may be desirable to use more than two plates, or in the alternative, to form the base as a single continuous plate. Exemplary embodiments utilizing single plate bases will be discussed in more detail below with reference to **FIGS. 6A****,** **6B,** and **6C****.**

With continuing reference to **FIGS. 4A****,** **4B,** and **4C****,** a cantilevered member **420,** which may be in the form of a spring finger, may extend from the base **410.** As illustrated, the spring finger **420** may be formed from a portion of the top plate **413** of the base **410.** Those skilled in the art will appreciate that the spring finger **420** need not consist of a displaced portion of the top plate **413.** Alternatively, and as will be discussed further below with reference to **FIGS. 6A****,** **6B,** and **6C****,** the spring finger **420** may be a separate component mechanically coupled to the base **410** by welding, adhesive, or one of many other known and suitable coupling means. Regardless of the nature of the connection between the spring finger **420** and the base **410,** the spring finger **420** may have a fixed end **422** and a free end **424.** The spring finger **420** is connected to the base **410** at its fixed end **422** which allows the spring finger **420** to flex and the free end **424** to move independently of the base **410** when a force is applied to the spring finger **420.**

The spring finger **420** may be configured to have a knuckled portion **426** between its fixed **422** and free **424** ends. The knuckled portion **426** may be a portion of the spring finger **420** that lies proud of the base **410** (i.e. extends upwardly from the base **410).** The knuckled portion **426** may be formed by bending the spring finger **420** into curvilinear form to produce a hump between the fixed end **422** and the free end **424** of the spring finger **420** (as best illustrated in **FIG. 4B****).** Those skilled in the art will appreciate that the knuckled portion **426** may for example be formed as a smoothly curved surface and/or may be formed with sharp bends which may produce a spring finger **420** with a flat or a pointed apex. Various configurations are possible. As will be discussed below, the spring finger **420** will be subject to certain forces that will cause it to flex. Therefore, the spring finger **420** may comprise a suitably resilient material that can bend without failing in response to certain applied forces. As will be discussed in more detail below, the spring finger **420** comprises a conductive material. Examples of conductive and sufficiently resilient materials suitable for a spring finger **420** include, but are not limited to, stainless steel (e.g. SS 301, SS 304, and the like), aluminum, copper, tin, platinum, and silver.

A channel **430** may be formed out of the base **410** in order to accommodate the spring finger **420.** In the case of a grounding component **400** having a base **410** consisting of two plates (such as that shown in **FIGS. 4A****,** **4B,** and **4C****),** the channel **430** may correspond to a void produced in the base **410** resulting from displacing the material comprising the spring finger **420** (as will be discussed below). Furthermore, the channel **430** may have a depth **432** approximately equal to the thickness **414** of the top plate **413.** Where a grounding component has a base consisting of a single plate (such as grounding component **400"** in **FIGS. 6A****,** **6B,** and **6C****),** an appropriately shaped mold may be used to produce the base having a channel. In the single plate embodiment, the depth of the channel may be larger than the thickness of the spring finger.

It will be understood by those skilled in the art that the channel **430,** as referred to herein, comprises a backstop portion **418** against which the free end **424** of the spring finger **420** will press when in a second depressed position (which will be described in further detail below). Referring briefly to **FIG. 4B****,** in the embodiment depicted, a portion **418** of the upper surface of the bottom plate **416** (which serves as a floor **434** of the channel **430**) provides the backstop portion **418** for the channel **430.** The backstop portion **418** may be formed of metal or other material of suitable strength capable of being coupled to the base **410** in an appropriate location. As discussed below, the backstop portion **418** need not span the entire length of the channel **430.** Those skilled in the art will appreciate that a hole through a single plate lacking a backstop portion is not intended to constitute a "channel" **430,** as the term is used herein throughout (including in the claims).

**FIG. 4B****,** which shows a sectional view of the grounding component **400** of **FIG. 4A** along section line A4―A4, illustrates the shape of the spring finger **420** of the grounding component **400.** The spring finger **420** is shown in a first undepressed position. It can be said that the spring finger **420** is flexibly biased toward this first position as, in the absence of any externally applied forces, the spring finger **420** will settle in this position. When in the first position, the knuckled portion **426** of the spring finger **420** may lie proud of, or protrude from, the base **410.** That is, when the grounding component **400,** with the spring finger **420** in the first undepressed position, is viewed from the side, the knuckled portion **426** of the spring finger **420** may be elevated with respect to the base **410,** and may be situated above the channel **430** formed in the base **410.** The particular shape of the spring finger **420** may be such that the free end **424** of the spring finger **420** is redirected toward the base **410** and caused to lie substantially within the channel **430** of the base **410** when in the first undepressed position. In some instances at least one quarter of the thickness of the free end **424** of the spring finger **420** lies within the channel **430** when the spring finger **420** is in the first undepressed position. In other instances, the entire thickness **414** of the free end **424** of the spring finger **420** may lie within the channel **430** when the spring finger **420** is in the first undepressed position.

One advantage of configuring the free end **424** of the spring finger **420** to lie substantially within the channel **430** when the spring finger **420** is in the first undepressed position is that in this configuration, the channel **430** may partially protect the free end **424** of the spring finger **420** from snagging, and therefore may help to reduce the chances of the spring finger **420** sustaining damage by nearby moving objects during shipping and/or handling.

**FIG. 4C** illustrates a section view of the grounding component **400** of **FIG. 4A** along section line A4―A4 in a second depressed position as a result of a force F applied to the spring finger **420.** The force **F,** which may be applied to the knuckled portion **426** of the spring finger **420,** may act to push the spring finger **420** toward the channel **430.** As indicated above, the backstop portion **418** of the base **410** acts as a backstop to the spring finger **420,** limiting displacement of the free end **424** in the direction of the applied force **F.** In the embodiment illustrated, the portion of the bottom plate **416** defining the floor **434** of the channel **430** acts as the backstop portion **418.** In other embodiments, the backstop may not extend the entire length of the channel **430.** Those skilled in the art will appreciate that the backstop need only be present where contact is to be established between it and the free end **424** of the spring finger **420** as a result of the force **F.** The backstop may consist of any material having adequate hardness and strength properties to limit displacement of the free end **424** of the spring finger **420** in the direction of the applied force **F.**

The combination of the applied force **F** and the backstop portion **418** may cause the spring finger **420** to have a less pronounced knuckled portion **426** when in the second depressed position than when in the first undepressed position. That is, when the spring finger **420** is in the second depressed position, the knuckled portion **426** may protrude above the base **410** to a lesser extent than when in the first undepressed position. The shape of the free end **424** of the spring finger **420** may be configured such that the combination of the applied force **F** and the backstop may cause the free end **424** of the spring finger **420** to approach a far wall **436** of the channel **430.**

The force **F** applied to the spring finger **420** (e.g. by a printed circuit board assembly, as discussed further below) causes the free end **424** of the spring finger **420** to move toward the floor **434** of the channel **430.** The backstop portion **418** of the base **410** limits the vertical movement of the free end **424** of the spring finger **420,** and as a result of the appropriate curvilinear shape of the spring finger **420,** causes the spring finger **420** to partially flatten out as the free end **424** of the spring finger **420** moves toward the far wall **436** of the channel **430.** A portion of the contact force exerted on the free end **424** of the spring finger **420** by the backstop portion **418** may cause the knuckled portion **426** of the spring finger **420** to exert a force against the source of the force **F.** The resulting increased contact force between the spring finger **420** and the source of the force **F** may help to ensure a consistent electrical connection between the base **410** and the source of the force **F** via the spring finger **420,** which in turn may help ensure the continuous grounding of the source of the force **F** (e.g. a printed circuit board assembly) via the spring finger **420** and/or grounded base **410** (acting as a reference potential).

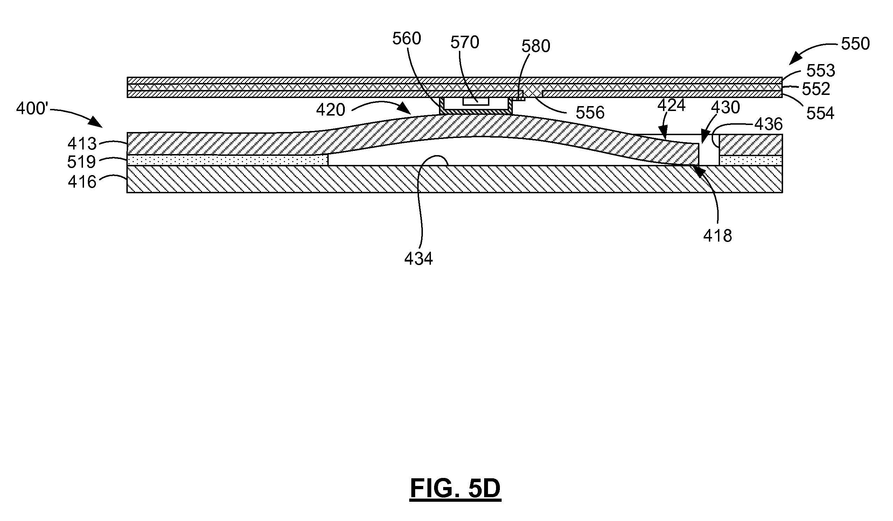

The spring finger **420** may comprise a conductive material, including but not limited to metals such as stainless steel (e.g. SS 301, SS 304, and the like), aluminum, copper, tin, platinum, and silver, in order for it to be a suitable electrical conductor. It will be appreciated by those skilled in the art that the electrical connection between the spring finger **420** and the backstop portion **418** of the base **410** is not required in order for the grounding component **400** to act as an electrical ground. The backstop may merely serve to apply a force to the spring finger **420** (at the free end **424**) in a direction generally toward the source of the force **F** so as to help maintain the physical connection (and hence electrical connection) between the spring finger **420** and the source of the force **F.** Therefore, the backstop portion **418** of the base **410** need not be made of a conductive material. As discussed above, the backstop may be made of a material with strength characteristics suitable to counteract movement of the free end **424** of the spring finger **420** resulting from the applied force **F.** In some embodiments, as will be described further below with relation to **FIG. 5D****,** it may be desirable to provide a conductive bottom plate **416** that may act to help shield against electromagnetic interference (EMI) emissions emanating from an electronic component mounted to, or otherwise operatively coupled to the grounding component **400.**

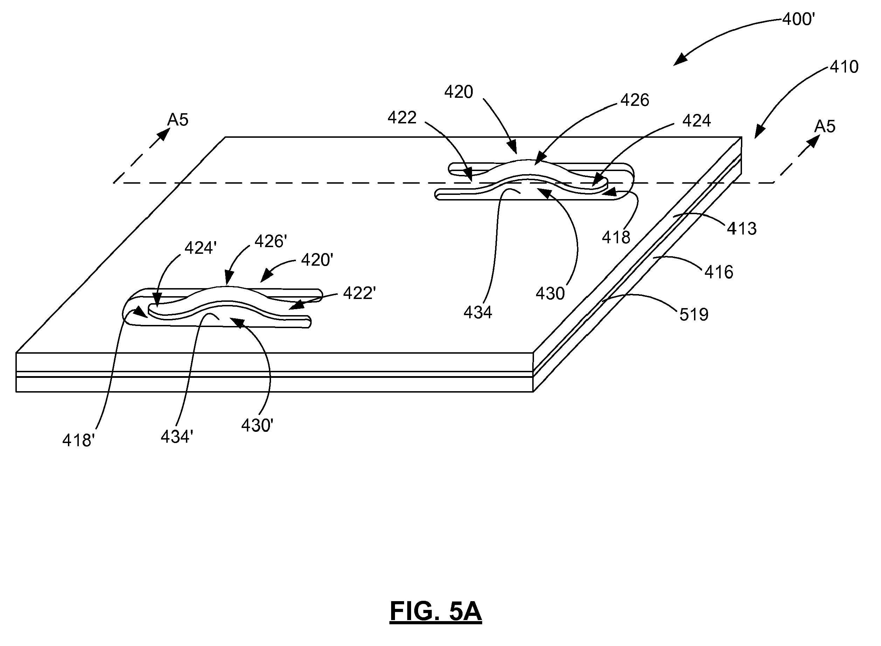

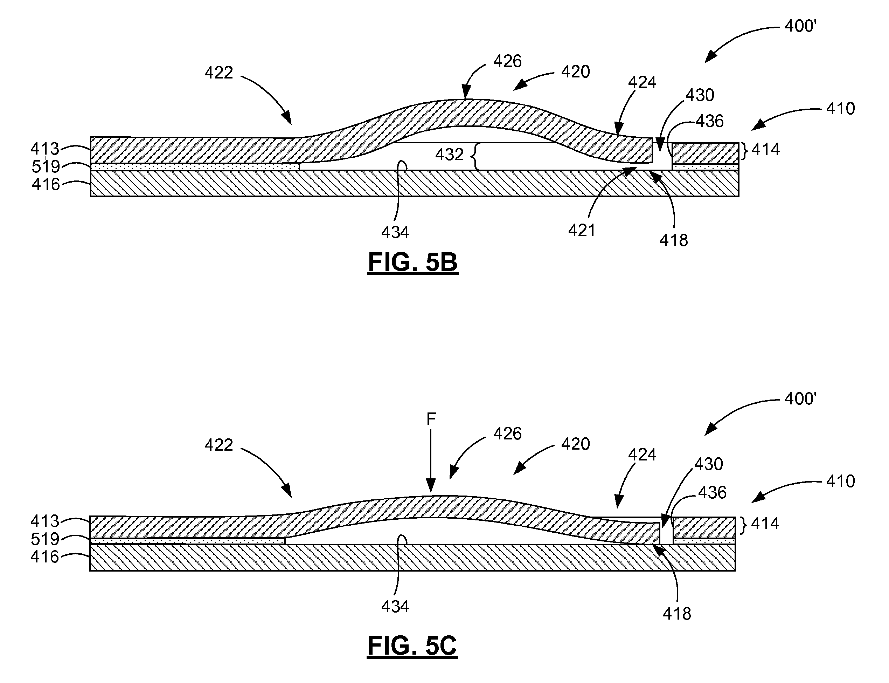

Reference is now made to **FIGS. 5A****,** **5B****,** **5C****,** and **5D** which illustrate a grounding component **400'** according to another embodiment of the present invention. For clarity, elements in **FIGS. 5A****,** **5B****,** **5C****,** and **5D** similar to those in the embodiment of **FIGS. 4A****,** **4B,** and **4C** are designated with the same reference numeral (which in some cases may also include an apostrophe).

The grounding component **400'** of the embodiment of **FIG. 5A** may have a plurality of spring fingers **420, 420'** and corresponding channels **430, 430'.** The grounding component **400'** may include a first spring finger **420** having a first corresponding channel **430** and at least one second spring finger **420'** having a corresponding second channel **430'.**

In this embodiment, the top plate **413** and bottom plate **416** of the grounded base **410** may be secured to one another using an adhesive **519.** The adhesive **519** may be applied to the entire bottom surface of the top plate **413,** or in the alternative, may be applied to a suitable number of predetermined locations on the bottom surface of the top plate **413** to hold the top and bottom plates **413, 416** together. In some instances, the adhesive **519** may act as a sealing agent and may be configured to prevent water, dust, and other impurities from reaching the channels **430, 430'** and hindering the performance of the grounding component **400'** (or any operatively coupled electronic component). Applying adhesive **519** to the entire bottom surface of the top plate **413** may be advantageous in that a larger layer of adhesive may provide a better seal for the channels **430, 430'** than adhesive **519** applied in localized zones. As discussed further below, the adhesive **519** used may be electrically conductive or non-conductive, depending on the particular application.

Specific reference is now made to **FIG. 5B****,** in which a section view of the grounding component **400'** of **FIG. 5A** through section line A5―A5 is shown; the grounding component **400'** is depicted in a first undepressed position. As illustrated, the floor **434** of the channel **430** may be free of adhesive **519** so as to permit physical contact and electrical connection between the free end **424** of the spring finger **420** and the backstop portion **418** of the base **410** when the spring finger **420** is in the second depressed position. Ensuring that the floor **434** of the channel **430** is free of adhesive **519** may be necessary in embodiments in which the adhesive layer **519** is non-conductive. Such configurations may be necessary to ensure that an electrical connection may be established between the free end **424** and the bottom plate **416** of the base **410.** In other embodiments―where the adhesive **519** and the bottom plate **416** of the base **410** are electrically conductive, and the spring finger **420** consists of a continuous portion of the top plate **413**―an electrical connection may be established between the spring finger **420** and the bottom plate **416** when the spring finger **420** is in the first undepressed position via the electrically conductive adhesive **519** layer. In such embodiments, the electrical connection is established regardless of whether or not the free end **424** of the spring finger **420** is in contact with the backstop portion **418** of the base **410.**

In those embodiments where it may be preferable to use an electrically non-conductive adhesive **519** to prevent electrical connection between the spring finger **420** and the bottom plate **416** when the spring finger **420** is in the first undepressed position, when the spring finger **420** is in the first undepressed position, the free end **424** of the spring finger **420** may be out of direct contact with the backstop portion **418** of the base **410,** as illustrated by the gap **421** in **FIG. 5B** (and in contrast to the embodiment of **FIG. 4B**).

As in the embodiment depicted in **FIGS. 4A****,** **4B,** and **4C****,** when the spring finger **420, 420'** is in the first depressed position, the free end **424, 424'** of the spring finger **420, 420'** lies substantially within the channel **430, 430'** formed within the base **410** of the grounding component **400'**. Accordingly, the underside of the free end **424** of the spring finger **420** is unexposed (or contained within the base **410**), resulting in a grounding component **400'** having a spring finger with decreased susceptibility to snagging (and corresponding damage) while in the undepressed position-e.g. during shipping and handling of the grounding component **400'**.

**FIG. 5C** shows a section view of the grounding component **400'** along section line A5―A5 (**FIG. 5A**); the grounding component **400'** is in a second depressed position as a result of a force **F** applied to the spring finger **420**. As with the grounding component **400** of **FIG. 4C****,** the force F may cause movement of the spring finger **420** toward the floor **434** of the channel **430**. The force **F** may cause the spring finger **420** to partially flatten out, resulting in a less pronounced knuckled portion **426** in a depressed position than in an undepressed position. When the free end **424** of the spring finger **420** contacts the portion of the base **410** acting as the spring finger backstop, displacement of the free end **424** in the general direction of the applied force **F** may be translated into displacement along the channel **430** floor **434** toward the far wall **436** of the channel **430**. Contact forces between the backstop portion **418** of the base **410** and the free end **424** of the spring finger **420,** and the source of the force **F** and the spring finger **420,** may establish an electrical connection between the respective components.

With reference to **FIG. 5D****,** a section view of the grounding component **400'** along section line A5―A5 is shown; the grounding component **400'** is in a second depressed position as a result of a force **F** (as shown in **FIG. 5C**) exerted on the knuckled portion **426** of the spring finger **420** by an electrical contact point of an electronic component **550**. In some embodiments the electronic component **550** may be a printed circuit board assembly **550**. A printed circuit board assembly **550** may consist of a ground plane **552** located between two exterior layers **553, 554.** The ground plane **552,** which may be a conductive layer or a portion thereof, may be used as a common reference point for circuit returns. A portion of the ground plane **552** may penetrate the lower exterior layer **554** to form an exposed electrical contact point (or grounding pad) **556.** Those of ordinary skill in the art will appreciate that the electrical contact point **556** may be flush with the bottom surface of the lower exterior layer **554** of the printed circuit board assembly **550**, or alternatively may protrude from the bottom surface of the lower exterior layer **554**.

In the embodiment shown, the printed circuit board assembly **550** has a metal or conductive-coated plastic case **560** to shield electro-magnetic interference (EMI) emissions emanating from a radio frequency (RF) chip **570** of the printed circuit board assembly **550**. A solder joint **580** may connect the case **560** to the grounding pad 556 in order to establish an electrical connection between the two components. The metal case **560** may also be referred to as a metal can.

The printed circuit board assembly **550** and grounding component **400**' may be appropriately positioned and secured within a housing (not shown) of an electronic device such that the metal or conductive-coated case **560** exerts a downward force on the spring finger **420** of the grounding component **400**', causing the spring finger **420** to assume the second depressed position. Those ordinarily skilled in the art will appreciate that in alternate embodiments, the printed circuit board assembly **550** need not have a metal or conductive-coated case **560**. In such embodiments, the printed circuit board assembly **550** and the grounding component **400**' may be secured within a housing (not shown) of an electronic device such that the knuckled portion **426** of the spring finger **420** lines up with the grounding pad **556** to establish direct physical contact (and hence an electrical contact) between the spring finger **420** and the electrical contact point **556** of the printed circuit board assembly **550** (e.g. the grounding pad).

In embodiments having a plurality of spring fingers **420**, **420**' and corresponding channels **430**, **430**', the printed circuit board assembly **550** may have a corresponding number of electrical contact points **556** (e.g. metal cans or grounding pads) for electrical engagement with the spring fingers **420**, **420**' when the printed circuit board assembly **550** and grounding component **400**' are mounted within the housing of an electronic device. Some embodiments of the present invention may incorporate as many as eight or more spring fingers. Those skilled in the art will appreciate that grounding components according to the present invention may be manufactured with any number of spring fingers and corresponding channels. The number of spring finger and channel combinations may be dependent on the overall size of the electronic component to be grounded.

As mentioned above, the printed circuit board assembly **550** may be positioned with the housing of an electronic device. The electronic device may be a mobile device **100** as described above in relation to FIGS. 1 through 3. A mobile device **100** may include, but not be limited to a cellular telephone and/or a personal digital assistant (PDA). More specifically, the printed circuit board assembly may form part of the keypad assembly within a mobile device. The keypad assembly may include a keyboard **116** as described above in relation to **FIG**. **1****.** Example keypad assemblies that may be used with embodiments of the present invention include, but are not limited to, twelve-key telephone keypads and QWERTY keyboards. Those skilled in the art will appreciate that the grounding components according to the present invention may be used with any variation of keypad assembly.

As discussed briefly above, the bottom plate **416** need not comprise a conductive material in order for the grounding component **400**' to provide a reference ground to the electronic component **550**. In some embodiments, however, it may be desirable to use a conductive bottom plate 416 as it may help shield a part of the surrounding environment from electromagnetic interference (EMI) emissions emanating from the electronic component **550**.

Reference is now made to **FIGS**. **6A**, **6B**, and **6C**, which illustrate another embodiment of the present invention. For clarity, elements in **FIGS. 6A**, **6B**, and **6C** similar to those in the embodiment of **FIGS. 4A****,** **4B,** and **4C** are designated with the same reference numeral (which in some cases may also include a double apostrophe).

Grounding component **400"** is similar to grounding components **400**, **400'** except that the grounded base **410** is made of a single plate **615**. The channel **430** may be formed during the manufacturing of the plate **615** by selecting an appropriately shaped mold therefor. The spring finger **420** may be formed independently from the plate **615** and coupled to the floor **434** of the channel **430** formed within the base **410**. The fixed end **422** of the spring finger **420** may be coupled to the base **410** using any suitable coupling means known in the art including, but not limited to, adhesive bonding and welding.

**FIG. 6B** shows a section view of the grounding component **400"** with the spring finger **420** in a first undepressed position. The free end **424** of the spring finger **420** may be remote from the floor **434** of the channel **430** when in this position.

As illustrated in **FIG. 6C**, and as described in more detail above with respect to **FIG. 4C**, the combination of a force F applied to the spring finger **420** (e.g. by a printed circuit board assembly) and the backstop portion **418** of the base **410** pushing back against the free end **424** of the spring finger **420**, may result in a stronger contact force between the source of the force F and the spring finger **420**. As further described above, the stronger contact force may help to ensure a consistent electrical connection between the base **410** and the source of the force F via the spring finger **420,** which in turn may help ensure the continuous grounding of the source of the force F (e.g. a printed circuit board assembly) via the spring finger **420** and/or grounded base **410** (acting as a reference potential).

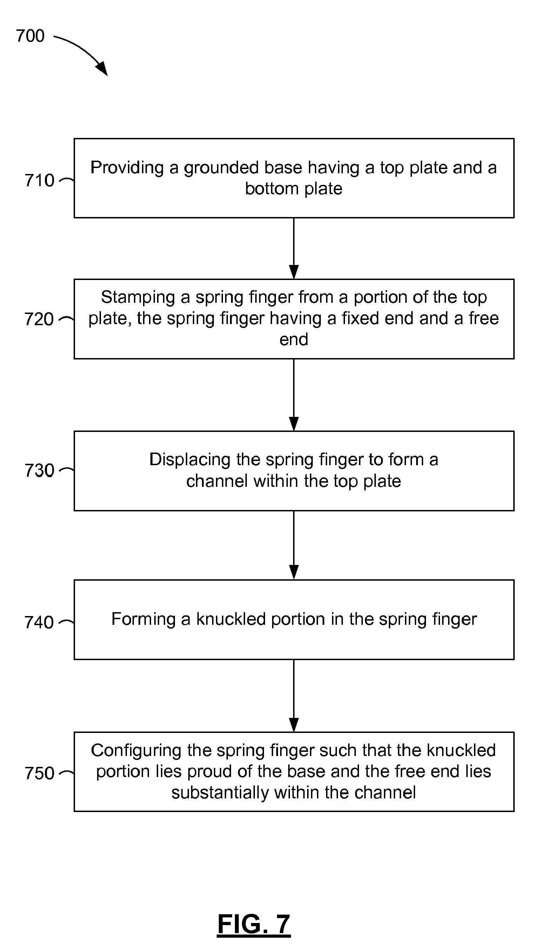

With reference to the logical flow diagram of **FIG. 7**, a method of manufacturing a grounding component (referred to generally as **700**) will now be discussed. A grounded base **410**, in some instances having a top plate **413** and a bottom plate **416**, may be provided at Block **710**. At Block **720**, a spring finger **420** may be partially stamped from a portion of the top plate **413**. The spring finger **420** may have a fixed end **422** and a free end **424**. At Block **730**, the spring finger **420** may be displaced to form a channel **430** within the top plate **413** of the base **410**. At Block **740**, a knuckled portion **426** may be formed in the spring finger **420**. The knuckled portion **426** may be formed by bending or otherwise configuring the spring finger **420** to have a humped portion or raised apex between its fixed end **422** and its free end **424**. At Block **750**, the spring finger **420** may be configured such that the knuckled portion **426** lies proud of the base **410** and the free end **424** lies substantially within the channel **430** of the base 410.

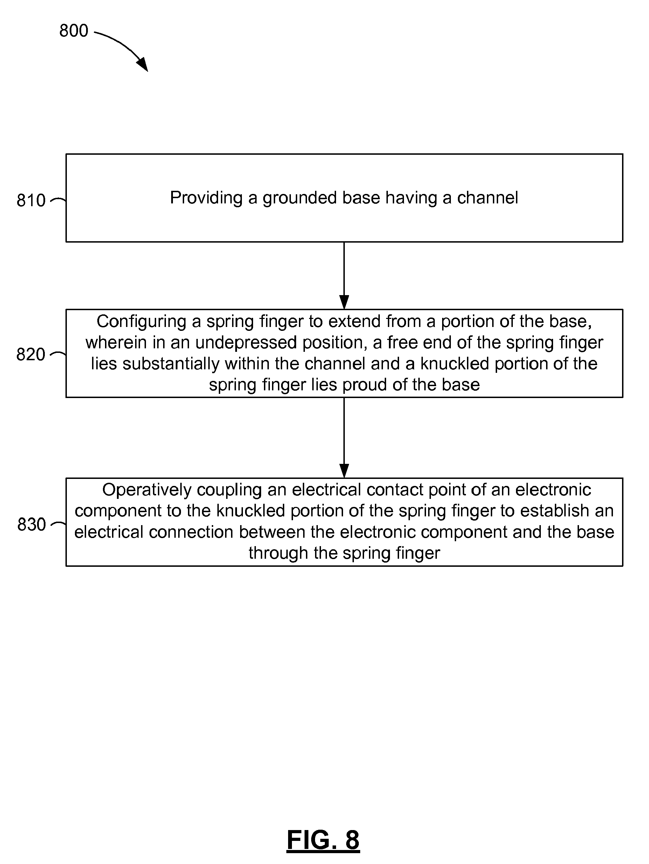

With reference to the logical flow diagram of **FIG. 8**, a method for grounding an electronic component (referred to generally as **800**) will now be discussed. A grounded base **410** having a channel **430** may be provided at Block **810**. As discussed above, the base **410** may comprise a single plate or may alternatively consist of a plurality of plates secured to one another. Where a plurality of plates makes up the base **410**, the plates may be secured together using common coupling techniques including, but not limited to, adhesive bonding and welding. The bottom plate **416** of a multi-plated base may comprise a conductive or non-conductive material.

At Block **820**, a spring finger **420** may be configured to extend from a portion of the base **410**. The spring finger **420** may be formed as a part of a top plate **413** of a multi-plated base or may be a separate component coupled to a single- or multi-plated base. When the spring finger **420** is in an undepressed position, a free end **424** of the spring finger **420** is configured to lie substantially within the channel **430** of the base **410**, and a knuckled portion **426** of the spring finger **420** is configured to lie proud of the base **410**. The knuckled portion **426** of the spring finger **420** may be formed by bending a hump shape or pointed apex into the spring finger **420**. The spring finger **420** may comprise a conductive material.

At Block **830**, the electrical contact point **556** of an electronic component is operatively coupled to the knuckled portion **426** of the spring finger **420**. Sustained physical contact between the electrical contact point **556** and the knuckled portion **426** may help to establish a consistent electrical connection between the electronic component and the base **410** via the spring finger **420**. The spring finger **420** and base **410** may comprise an electrically conductive material (e.g. a metal or metal alloy) in order to act as a ground (or reference potential) for the electronic component when electrically coupled thereto. The consistent electrical connection between the electronic component and the base **410** (via the electrical contact point and the spring finger **420**) may help ensure continuous grounding of the electronic component. The electronic component may comprise a printed circuit board assembly **550** of the type typically used in conjunction with a mobile device **100**. Further the printed circuit board may form part of a keypad assembly.

The steps of a method in accordance with any of the embodiments described herein may not be required to be performed in any particular order, whether or not such steps are described in the claims or otherwise in numbered or lettered paragraphs.

The present grounding component has been described with regard to a number of embodiments. However, it will be understood by persons skilled in the art that other variants and modifications may be made without departing from the scope of the present disclosure as defined in the claims appended hereto.

## Claims

1. A grounding component (400, 400', 400") comprising:
- a grounded base (410);
- a channel (430) formed within the base (410);
- a spring finger (420) extending from the base (410), the spring finger (420) having a fixed end (422) and a free end (424); and
wherein when the spring finger (420) is in a first undepressed position, a knuckled portion (426) of the spring finger (420) lies proud of the base (410), and the free end (424) of the spring finger (420) lies substantially within the channel (430).

2. The grounding component (400, 400') according to claim 1, wherein the base comprises a top plate (413) secured to a bottom plate (416).

3. The grounding component (400, 400') according to claim 2, wherein the top plate (413) and bottom plate (416) are secured using an adhesive (519).

4. The grounding component (400, 400') according to claim 2 or claim 3, wherein the channel (430) extends through an entire thickness (414) of the top plate (413).

5. The grounding component (400,400') according to any of claims 2 to 4, wherein the spring finger (420) is stamped from the top plate (413) and displaced to form the channel (430) within the top plate (413).

6. The grounding component (400, 400') according to claim 3, wherein the adhesive (519) is non-conductive and wherein when the spring finger (420) is in a second depressed position, an electrical connection is established between the top plate (413) and the bottom plate (416) through the spring finger (420).

7. The grounding component (400, 400', 400") according to any of claims 1 to 6, wherein the fixed end (422) of the spring finger (420) is welded to the base (410).

8. The grounding component (400, 400', 400") according to any of claims 1 to 7, wherein the spring finger (420) comprises a conductive material.

9. The grounding component (400, 400', 400") according to any of claims 1 to 8, further comprising at least one second channel (430') and at least one second spring finger (420').

10. A grounding system (400, 400') comprising:
- a grounded base (410) having a top plate (413) secured to a bottom plate (416);
- a channel (430) formed within the top plate (413);
- a cantilevered member (420) extending from the base (410), the cantilevered member (420) being flexibly biased towards a first undepressed position; and
wherein in a second depressed position, the cantilevered member (420) is in electrical contact with the bottom plate (416).

11. The grounding (400, 400') system according to claim 10, wherein the cantilevered member (420) has a free end (424) and a fixed end (422), and wherein when the cantilevered member (420) is in the first undepressed position, a knuckled portion (426) of the cantilevered member (420) lies proud of the base (410), and the free end (424) of the cantilevered member (420) lies substantially within the channel (430).

12. The grounding system (400, 400') according to claim 10 or claim 11, wherein when the cantilevered member (420) is in the first undepressed position, the top plate (413) and the bottom plate (416) are not in electrical communication.

13. The grounding system (400, 400') according to any of claims 10 to 12, further configured for receivably mounting an electronic component (550) to the base (410), and wherein when the electronic component (550) is mounted to the base (410), an electrical connection is established between the electronic component (550) and the base (410) through the cantilevered member (420), for grounding the electronic component (550).

14. The grounding system (400, 400') according to claim 13, wherein the electronic component (550) comprises a printed circuit board assembly.

15. A method of grounding an electronic component (550), the method comprising:
providing a grounded base (410) having a channel (430);
configuring a spring finger (420) to extend from a portion of the base (410),
wherein when in an undepressed position, a free end (424) of the spring finger (420) lies substantially within the channel (430), and a knuckled portion (426) of the spring finger (420) lies proud of the base (410); and
operatively coupling an electrical contact point of the electronic component (550) to the knuckled portion (426) of the spring finger (420) to establish an electrical connection between the electronic component (550) and the base (410) through the spring finger (420).

## Amended claims

### Amended claims in accordance with Rule 137(2) EPC.

**1.** A grounding component (400, 400', 400") comprising:
- a grounded base (410);
- a channel (430) formed within the base (410);
- a spring finger (420) extending from the base (410), the spring finger (420) having a fixed end (422) and a free end (424); and
wherein when the spring finger (420) is in a first undepressed position, a knuckled portion (426) of the spring finger (420) lies proud of the base (410), and the free end (424) of the spring finger (420) lies substantially within the channel (430).

**2.** The grounding component (400, 400') according to claim 1, wherein the base comprises a top plate (413) secured to a bottom plate (416).

**3.** The grounding component (400, 400') according to claim 2, wherein the top plate (413) and bottom plate (416) are secured using an adhesive (519).

**4.** The grounding component (400, 400') according to claim 2 or claim 3, wherein the channel (430) extends through an entire thickness (414) of the top plate (413).

**5.** The grounding component (400,400') according to any of claims 2 to 4, wherein the spring finger (420) is stamped from the top plate (413) and displaced to form the channel (430) within the top plate (413).

**6.** The grounding component (400, 400') according to claim 3, wherein the adhesive (519) is non-conductive and wherein when the spring finger (420) is in a second depressed position, an electrical connection is established between the top plate (413) and the bottom plate (416) through the spring finger (420).

**7.** The grounding component (400, 400', 400") according to any of claims 1 to 6, wherein the fixed end (422) of the spring finger (420) is welded to the base (410).

**8.** The grounding component (400, 400', 400") according to any of claims 1 to 7, wherein the spring finger (420) comprises a conductive material.

**9.** The grounding component (400, 400', 400") according to any of claims 1 to 8, further comprising at least one second channel (430') and at least one second spring finger (420').

**10.** A grounding system (400, 400') comprising:
- a grounded base (410) having a top plate (413) secured to a bottom plate (416);
- a channel (430) formed within the top plate (413);
- a cantilevered member (420) extending from the base (410), the cantilevered member (420) being flexibly biased towards a first undepressed position;
wherein in a second depressed position, the cantilevered member (420) is in electrical contact with the bottom plate (416);and wherein the cantilevered member (420) has a free end (424) and a fixed end (422), and wherein when the cantilevered member (420) is in the first undepressed position, a knuckled portion (426) of the cantilevered member (420) lies proud of the base (410), and the free end (424) of the cantilevered member (420) lies substantially within the channel (430).

**11.** The grounding system (400, 400') according to claim 10, wherein when the cantilevered member (420) is in the first undepressed position, the top plate (413) and the bottom plate (416) are not in electrical communication.

**12.** The grounding system (400, 400') according to any of claims 10 to 11, further configured for receivably mounting an electronic component (550) to the base (410), and wherein when the electronic component (550) is mounted to the base (410), an electrical connection is established between the electronic component (550) and the base (410) through the cantilevered member (420), for grounding the electronic component (550).

**13.** The grounding system (400, 400') according to claim 12, wherein the electronic component (550) comprises a printed circuit board assembly.

**14.** A method of grounding an electronic component (550), the method comprising:
providing a grounded base (410) having a channel (430);
configuring a spring finger (420) to extend from a portion of the base (410),
wherein when in an undepressed position, a free end (424) of the spring finger (420) lies substantially within the channel (430), and a knuckled portion (426) of the spring finger (420) lies proud of the base (410); and operatively coupling an electrical contact point of the electronic component (550) to the knuckled portion (426) of the spring finger (420) to establish an electrical connection between the electronic component (550) and the base (410) through the spring finger (420).
